(19) **Europäisches Patentamt**
**European Patent Office**
**Office européen des brevets**

(11) **EP 2 738 204 B1**

(12) **EUROPEAN PATENT SPECIFICATION**

(45) Date of publication and mention
of the grant of the patent:
**09.01.2019 Bulletin 2019/02**

(51) Int Cl.:
*C08K 3/22* (2006.01)       *C08K 3/26* (2006.01)
*C08K 3/30* (2006.01)       *C08K 5/00* (2006.01)
*C08L 67/02* (2006.01)      *F21V 7/00* (2006.01)
*H01L 33/00* (2010.01)

(21) Application number: **13193191.7**

(22) Date of filing: **15.11.2013**

(54) **POLYESTER COMPOSITIONS WITH IMPROVED CRYSTALLIZATION RATE**

POLYESTERZUSAMMENSETZUNGEN MIT VERBESSERTER
KRISTALLISATIONSGESCHWINDIGKEIT

COMPOSITIONS DE POLYESTER AVEC UN TAUX DE CRISTALLISATION AMÉLIORÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **29.11.2012 US 201261731051 P**
**15.02.2013 EP 13155500**

(43) Date of publication of application:
**04.06.2014 Bulletin 2014/23**

(73) Proprietor: **Solvay Specialty Polymers USA, LLC.
Alpharetta, GA 30005-3914 (US)**

(72) Inventor: **Bongiovanni, Alessandro
ALPHARETTA, GA Georgia 30022 (US)**

(74) Representative: **Benvenuti, Federica et al
Solvay S.A.
Département de la Propriété Intellectuelle
Rue de Ransbeek, 310
1120 Bruxelles (BE)**

(56) References cited:
**WO-A1-2012/141967**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field of the Invention**

The present invention relates to polymeric compositions comprising certain polyesters, at least one inorganic nucleating agent, and at least one plasticizer featuring a very good crystallization rate and excellent retention of light reflectance.

The present invention further provides an article comprising the composition of the invention, such as a part of a light emitting diode (LED) device.

**Background of the Invention**

LEDs are increasingly being used as light sources in numerous applications due to the high number of benefits they provide over traditional light sources. LEDs generally consume significantly less power than other light sources, require a low voltage to operate, and are resistant to mechanical shock. As a result, they are displacing incandescent and other light sources in many uses and have found applications in such disparate areas as traffic signals, interior and exterior lighting, cellular telephone displays, automotive displays and flashlights.

LED components, such as reflectors, require an especially demanding combination of excellent color and improved physical properties. Ceramics may be advantageously used in those applications, but are still extremely costly and require demanding processing technologies. Therefore, polymers have been extensively studied and developed to replace ceramics as a lower cost material. A great benefit of thermoplastic polymers is that they may be injection molded and therefore offer considerable design flexibility. One problem noted with the polymer compositions used for the manufacture of LED components is that they tend to yellow when exposed to light and elevated temperatures. For example, during manufacturing, the LED components are heated to about 180°C to cure an epoxy or silicon encapsulant. The LED components are also exposed to temperatures above 260°C while soldering operations are performed. In addition, while in use, LED components are routinely subjected to light and temperatures above 80°C. Moreover, the recent development of higher voltage LEDs leads to even higher working temperatures, generally above 100°C. This concurrent exposure to light and high temperatures causes yellowing of polymer compositions used for forming LED components.

Desirably, reflectors of LEDs and, *in fine,* the polymer compositions from which they are made, should comply with a wide set of requirements, including, notably, high reflectance of light, high whiteness, high dimensional stability, high mechanical strength, high heat deflection temperature, and high heat resistance (low discoloration and low loss of reflectance when exposed to a high temperature) while being easily processed into the desired shapes.

Polyesters are often used to manufacture shaped articles for use in a wide range of applications, including films, sheets, profiles, bottles, and the like. The most commonly used polyesters are based on terephthalic acid or 2,6-naphthalene dicarboxylic acid, and include, for example, poly(ethylene terephthalate) ("PET"), poly(1,4-butylene terephthalate) ("PBT"), poly(cyclohexylenedimethylene terephthalate) ("PCT"), poly(cyclohexylenedimethylene naphthalate) ("PCN"), poly(ethylene naphthalate) ("PEN") and their copolyesters. These polyesters are relatively inexpensive, widely available and, because of their aromatic content, have a high glass transition temperature (Tg), which gives shaped articles made there from thermal resistance, stiffness and toughness.

In spite of these positive characteristics, certain polyesters such as PET and PCT possess some limitations. One of the most significant limitations is their low rate of crystallization. During the injection molding process, the crystallization rate of the polymer being molded determines the cycle time, the minimum required mold temperature and the ease of ejection of the part from the mold (avoiding cracks and/or deformation). High degree of crystallinity is also often desirable in molded parts, due to the higher thermal and mechanical stability associated with it. Crystallinity is thus especially desirable when molding parts are to be subjected to elevated temperatures, such as parts of LED devices.

Prior art methods to increase the rate of crystallization of polyesters have been directed toward incorporation of nucleating agents. While the use of certain nucleating agents such as inorganic compounds increases somewhat the crystallization rate, some processing conditions such as injection molding require even higher crystallization rates. Other types of nucleating agents such as organic salts provide with the higher crystallization rates required but tend to create color bodies when exposed at the high temperatures of the LEDs manufacturing process.

One of ordinary skill in the art will recognize that further improvements in heat stability, molding performance and reflectance are advantageous for the development of LED devices.

WO 2007/033129 discloses light-emitting diode assembly housings comprising PCT compositions comprising titanium dioxide, inorganic reinforcing agents or fillers, and oxidative stabilizers. Those compositions suffer from a very low whiteness index even after very mild heat treatment.

US 2012/0262927 relates to compositions suitable for molding LED reflectors comprising PCT, a white pigment and a reactive viscosity stabilizer such as a phenoxy resin or a non-aromatic epoxy resin. US'927 discloses in its examples PCT compositions comprising titanium dioxide, chopped glass fibers, 2 wt. % of talc and 8 other additives. Those compositions only achieve a maximum of about 84 % of whiteness index retention after 4 hours at 200°C.

WO 2012/141967 discloses certain white PCT-based polymer compositions. Unfortunately, none of the exemplified compositions show acceptable after aging reflectance data that would render them suitable for LED applications.

Thus, there exists a need in the art for a polyester composition featuring all the benefit of polyesters while presenting a high crystallization rate and a good retention of the reflectance/whiteness index even after heat and light exposure.

The inventor has discovered that the presence of two specific additives greatly enhances the behavior of certain white pigmented polyester compositions in terms of crystallization rate while maintaining an excellent reflectance after heat and light exposure.

The polyester compositions according to the present invention satisfy thus the above-mentioned requirements and will be described in detail hereafter.

## Summary of the Invention

In a first aspect, the present invention relates to a polymer composition (C) comprising :

- at least one polyester (P) comprising at least 50 mol % of recurring units comprising at least one cycloaliphatic group,
- at least one white pigment selected from the group consisting of $TiO_2$, ZnS, ZnO, $CeO_2$ and $BaSO_4$,
- at least one inorganic nucleating agent, and
- at least one plasticizer having a boiling point of at least 200°C, present in an amount of at least 1 wt. % and at most 4 wt. %, based on the total weight of the polymer composition (C), and selected from the group consisting of phthalate esters, trimellitate esters, benzoate esters, terephthalate esters, citrate esters, cyclohexane diacid esters and esters of oligomers/polymers of ethers.

In a second aspect, the present invention relates to articles comprising at least one part comprising the invented polymer composition (C) and, in particular, to parts of LED devices made from such polymer composition (C).

## Brief Description of the Drawing

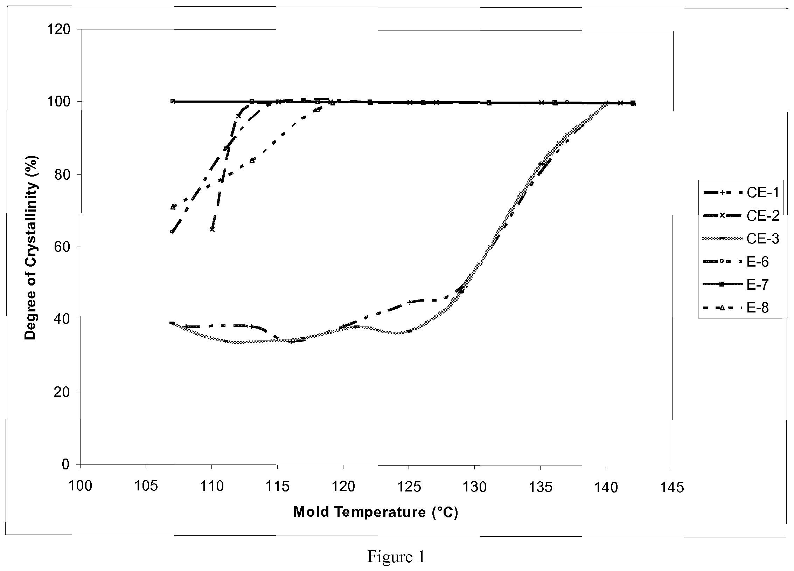

Figure 1 shows a graph depicting the degree of crystallinity of examples CE1, CE2, CE3, E6, E7 and E8 as a function of the mold temperature.

## Detailed Description of the Invention

The polymer composition (C) according to the present invention comprises four essential ingredients that are described in detail here below :

*The polyester (P)*

The term "polyester" is intended to include "copolyesters" and is understood to denote a polymer comprising at least 50 mol %, preferably at least 85 mol % of recurring units comprising at least one ester moiety (commonly described by the formula : R-(C=O)-OR'). Polyesters may be obtained by ring opening polymerization of a cyclic monomer ($M_A$) comprising at least one ester moiety ; by polycondensation of a monomer ($M_B$) comprising at least one hydroxyl group and at least one carboxylic acid group, or by polycondensation of at least one monomer ($M_C$) comprising at least two hydroxyl groups (a diol) and at least one monomer ($M_D$) comprising at least two carboxylic acid groups (a dicarboxylic acid). As used herein, the term dicarboxylic acid is intended to include dicarboxylic acids and any derivative of dicarboxylic acids, including their associated acid halides, esters, half-esters, salts, half-salts, anhydrides, mixed anhydrides, or mixtures thereof.

The polyester (P) comprises at least 50 mol %, preferably at least 60 mol %, more preferably at least 70 mol %, still more preferably at least 80 mol % and most preferably at least 90 mol % of recurring units comprising, in addition to the at least one ester moiety, at least one cycloaliphatic group. Excellent results were obtained when the polyester (P) was essentially composed of recurring units comprising at least one ester moiety and at least one cycloaliphatic group. The cycloaliphatic group may derive from monomers ($M_A$), monomers ($M_B$), monomers ($M_C$) or monomers ($M_D$) comprising at least one group which is both aliphatic and cyclic.

Non limitative examples of monomers ($M_A$) include lactide and caprolactone.

Non limitative examples of monomers ($M_B$) include glycolic acid, 4-hydroxybenzoic acid and 6-hydroxynaphthalene-2-carboxylic acid.

Non limitative examples of monomers ($M_C$) include 1,4-cyclohexanedimethanol, ethylene glycol, 1,2-propanediol, 1,3-propanediol, 1,4-butanediol, 1,5-pentanediol, 1,6-hexanediol, 1,8-octanediol, 1,10-decanediol, 2,2,4-trimethyl 1,3-pentanediol, 2,2,4,4-tetramethyl-1,3-cyclobutanediol, and neopentyl glycol, while 1,4-cyclohexanedimethanol and neopentyl glycol are preferred.

Non limitative examples of monomers ($M_D$) include terephthalic acid, isophthalic acid, naphthalene dicarboxylic acids, 1,4-cyclohexane dicarboxylic acid, succinic acid, sebacic acid, and adipic acid, while terephthalic acid and 1,4-cyclohexane dicarboxylic acid are preferred.

When the polyester (P) is a copolymer, monomers ($M_C$) and ($M_D$) are preferably used. In such a case, monomer ($M_C$) is preferably 1,4-cyclohexanedimethanol and monomer ($M_D$) is preferably a mixture of terephthalic acid and 1,6-naphthalene dicarboxylic acid.

When the polyester (P) is a homopolymer, it may be selected from poly(cyclohexylenedimethylene terephthalate) ("PCT") and poly(cyclohexylenedimethylene naphthalate) ("PCN"). Most preferably, it is PCT (i.e. a homopolymer obtained through the polycondensation of terephthalic acid with 1,4-cyclohexylenedimethanol).

The polyester (P) has advantageously an intrinsic viscosity of from about 0.4 to about 2.0 dl/g as measured in a 60:40 phenol/tetrachloroethane mixture or similar solvent at about 30°C. Particularly suitable polyester (P) for this invention has an intrinsic viscosity of 0.5 to 1.4 dl/g.

The polyester (P) has a melting point, as measured by DSC according to ISO-11357-3, of advantageously at least 250°C, preferably at least 260°C, more preferably at least 270°C and most preferably at least 280°C. Besides, its melting point is advantageously of at most 350°C, preferably at most 340°C, more preferably at most 330°C and most preferably at most 320°C. Excellent results were obtained with a polyester (P) having a melting point ranging from 280°C to 320°C.

The polyester (P) is preferably present in an amount of at least 40 wt. %, more preferably at least 45 wt. %, still more preferably at least 47 wt. %, and most preferably at least 48 wt. %, based on the total weight of the polymer composition (C).

The polyester (P) is also present in an amount of advantageously at most 80 wt. %, preferably at most 75 wt. %, more preferably at most 70 wt. %, still more preferably at most 65 wt. %, and most preferably at most 60 wt. %, based on the total weight of the polymer composition (C).

Excellent results were obtained when the polyester (P) was present in the polymer composition (C) in an amount from about 45 to about 60 wt. %, preferably from about 48 to about 58 wt. %, based on the total weight of the polymer composition (C).

*The white pigment*

The polymer composition (C) also comprises at least one white pigment selected from the group consisting of $TiO_2$, ZnS, ZnO, $CeO_2$ and $BaSO_4$.

The white pigment is advantageously in the form of particles having a weight-average size (equivalent diameter) preferably of below 1 $\mu$m. Preferably, the weight-average size of the particles is of below 0.8 $\mu$m. Besides, it is preferably above 0.1 $\mu$m.

The shape of the particles is not particularly limited ; they may be notably round, flaky, flat, and so on.

The white pigment is preferably titanium dioxide ($TiO_2$). The form of titanium dioxide is not particularly limited and a variety of crystalline forms such as the anatase form, the rutile form, and the monoclinic type can be used. However, the rutile form is preferred due to its higher refraction index and its superior light stability. Titanium dioxide may or may not be treated with a surface treatment agent. Preferably the weight-average particle size of the titanium oxide is in the range of 0.15 $\mu$m to 0.35 $\mu$m.

The surface of the titanium dioxide particles will preferably be coated. The titanium dioxide will preferably be first coated with an inorganic coating and then with an organic coating. The titanium dioxide particles may be coated using any method known in the art. Preferred inorganic coatings include metal oxides. Organic coatings may include one or more of carboxylic acids, polyols, alkanolamines, and/or silicon compounds.

The white pigment is preferably present in an amount of at least 1 wt. %, preferably of at least 6 wt. %, more preferably of at least 8 wt. %, even more preferably of at least 10 wt. %, and most preferably of at least 15 wt. %, based on the total weight of the polymer composition (C). Besides, the white pigment is also preferably present in an amount of at most 50 wt. %, preferably of at most 40 wt. %, more preferably of at most 35 wt. %, even more preferably of at most 30 wt. %, and most preferably of at most 25 wt. %, based on the total weight of the polymer composition (C).

Excellent results were obtained when titanium dioxide was used in an amount of 10-40 wt. %, preferably of 15-25 wt. %, based on the total weight of the polymer composition (C).

*The inorganic nucleating agent*

The polymer composition (C) further comprises at least one inorganic nucleating agent, different from the above detailed white pigment.

The term "inorganic nucleating agent" is intended to denote mineral particles having a weight-average size (equivalent diameter) of at least 1 $\mu$m. Preferably, the weight-average size of the particles is of at least 2 $\mu$m. Besides, it is preferably at most 10 $\mu$m.

The inorganic nucleating agent is preferably selected from the group consisting of silica, talc, clay, alumina, mica, zirconia, tin oxide, tin indium oxide, antimony tin oxide, kaolin, calcium silicate, calcium carbonate, magnesium carbonate, zeolites, and the like. Excellent results were obtained when using talc.

The inorganic nucleating agent is preferably present in an amount of at least 0.5 wt. %, preferably of at least 1 wt. %, more preferably of at least 1.5 wt. %, even more preferably of at least 2 wt. % and most preferably of at least 2.5 wt. %, based on the total weight of the polymer composition (C). Besides, the inorganic nucleating agent is also preferably present in an amount of at most 10 wt. %, preferably of at most 8 wt. %, more preferably of at most 7 wt. %, even more preferably of at most 6 wt. %, and most preferably of at most 5 wt. %, based on the total weight of the polymer composition (C).

Excellent results were obtained when the inorganic nucleating agent was used in an amount of 1-5 wt. %, preferably of 2-4 wt. %, based on the total weight of the polymer composition (C).

*The plasticizer*

The polymer composition (C) further comprises at least one plasticizer. The term "plasticizer" is intended to denote any additive that decreases the viscosity of the polymer composition (C). The plasticizer of the polymer composition (C) is advantageously selected from the group consisting of phthalate esters, trimellitate esters, benzoate esters, terephthalate esters, citrate esters, cyclohexane diacid esters and polyether esters.

The plasticizer is an organic compound having a molecular weight of at least 150g/mol, preferably at least 200 g/mol, more preferably at least 250 g/mol.

The plasticizer has a boiling point of at least 200°C, preferably at least 240°C, more preferably at least 280°C, still more preferably at least 300°C.

In a first specific embodiment, the plasticizer is an organic compound comprising at least one aromatic group and at least two ester moieties (R-C(=O)-OR'). Such plasticizers include phthalate esters, trimellitate esters, benzoate di- and tri-esters and terephthalate esters.

Non-limitative examples of phthalate esters plasticizers include bis(2-ethylhexyl) phthalate, diisononyl phthalate, di-n-propyl phthalate, di-n-butyl phthalate, butyl benzyl phthalate diisodecyl phthalate, di-n-octyl phthalate, diisooctyl phthalate, dimethyl phthalate, diethyl phthalate, diisobutyl phthalate, di-n-hexyl phthalate, diisoheptyl phthalate, butyl benzyl phthalate, di-n-pentyl phthalate, dicyclohexyl phthalate, butyl decyl phthalate, n-octyl n-decyl phthalate, diisononyl phthalate, di(2-propyl heptyl) phthalate, diisodecyl phthalate, diundecyl phthalate, ditridecyl phthalate and diisotridecyl phthalate.

Non-limitative examples of trimellitate esters plasticizers include trimethyl trimellitate, tri-(2-ethylhexyl) trimellitate, trihexyl trimellitate, triheptyl trimellitate, trioctyl trimellitate, trinonyl trimellitate, tridecyl trimellitate. Excellent results were obtained when using trioctyl trimellitate.

Non-limitative examples of benzoate di- and tri-esters plasticizers include di- and triethylene glycol dibenzoate, neopentyl glycol dibenzoate and dipropylene glycol dibenzoate. Excellent results were obtained when using neopentyl glycol dibenzoate.

Non-limitative examples of terephthalate esters plasticizers include di-(2-ethylhexyl) terephthalate and di-octyl terephthalate.

In a second specific embodiment, the plasticizer is an organic compound comprising at least one aromatic group and one ester moiety (-R-C(=O)-OR'-). Such plasticizers include benzoate monoesters such as butyl benzoate, isodecyl benzoate and isononyl benzoate.

In a third specific embodiment, the plasticizer is an organic aliphatic compound comprising at least one ester moiety (-R-C(=O)-OR'-). Such plasticizers include citrate and cyclohexane diacids esters.

Non-limitative examples of citrate ester plasticizers include tributyl citrate, acetyl tributyl citrate, triethyl citrate, acetyl triethyl citrate and tri-2-ethylhexyl citrate.

Non-limitative examples of cyclohexane diacids ester plasticizers include di-isononyl cyclohexane dicarboxylate and bis(2-ethylhexyl) cyclohexane-1,2-dicarboxylate.

In a fourth specific embodiment, the plasticizer is a polyether ester. Polyether esters are intended to denote esters of alkyl glycols comprising at least three ether moieties (R-C-O-C-R').

Non-limitative examples of such polyether ester plasticizers include triethylene glycol dihexanoate, tetraethylene glycol diheptanoate, poly(ethylene glycol)-di-2-ethylhexanoate and poly(ethylene glycol) dilaurate. Excellent results were obtained when using PEG-400 di-2-ethylhexanoate, a low molecular weight poly(ethylene glycol)-di-2-ethylhexanoate of about 400 g/mol.

The plasticizer is preferably present in an amount of at least 1 wt. %, preferably of at least 2 wt. %, more preferably of at least 2.5 wt. %, even more preferably of at least 2.8 wt. %, and most preferably of at least 3 wt. %, based on the total weight of the polymer composition (C). Besides, the plasticizer is also preferably present in an amount of at most 4 wt. %, preferably of at most 3.8 wt. %, more preferably of at most 3.6 wt. %, even more preferably of at most 3.4 wt. %, and most preferably of at most 3.2 wt. %, based on the total weight of the polymer composition (C).

Excellent results were obtained when the plasticizer was used in an amount of 1-5 wt. %, preferably of 2-4 wt. %, based on the total weight of the polymer composition (C).

*Optional ingredients*

The polymer composition (C) may also further comprise at least another polyester, different from the above mentioned polyester (P), which may be selected from the group consisting of : polyglycolide or polyglycolic acid (PGA), polylactic acid (PLA), polycaprolactone (PCL), polyethylene adipate (PEA), polyhydroxyalkanoate (PHA), polybutylene terephthalate (PBT), polypropylene terephthalate (PPT), polytrimethylene terephthalate (PTT), polyethylene naphthalate (PEN), polybutylene naphthalate(PBN), polyethylene terephthalate (PET), and Liquid Crystalline Polyesters (LCP). It is preferably selected from the group consisting of PBT, PTT, PEN, PET and LCP. More preferably, it is selected from the group consisting of PBT and LCP.

When added to the polymer composition (C), the other polyester different from the polyester (P) is preferably present in an amount of at least 1 wt. %, preferably of at least 2 wt. %, more preferably of at least 3 wt. %, even more preferably of at least 4 wt. %, and most preferably of at least 5 wt. %, based on the total weight of the polymer composition (C). Besides, the other polyester is also preferably present in an amount of at most 20 wt. %, preferably of at most 15 wt. %, more preferably of at most 10 wt. %, even more preferably of at most 9 wt. %, and most preferably of at most 8 wt. %, based on the total weight of the polymer composition (C).

The polymer composition (C) may also comprise other polymers than the above mentioned polyesters such as polycarbonate, polyethylene glycol, polysulfone, PEEK, PTFE and polyphthalamide.

The polymer composition (C) may also further comprise at least one reinforcing filler.

Reinforcing fillers are preferably fibrous. More preferably, the reinforcing filler is selected from glass fiber, carbon fiber, synthetic polymeric fiber, aramid fiber, aluminum fiber, titanium fiber, magnesium fiber, boron carbide fibers, rock wool fiber, steel fiber, wollastonite, etc. Still more preferably, it is selected from glass fiber, carbon fiber and wollastonite.

A particular class of fibrous fillers consists of whiskers, i.e. single crystal fibers made from various raw materials such as $Al_2O_3$, SiC, BC, Fe and Ni. Among fibrous fillers, glass fibers are preferred ; they include chopped strand A-, E-, C-, D-, S- T- and R-glass fibers, as described in chapter 5.2.3, p. 43-48 of Additives for Plastics Handbook, 2nd ed., John Murphy.

In a preferred embodiment of the present invention the reinforcing filler is chosen from wollastonite and glass fiber. Excellent results were obtained when wollastonite and/or glass fibers were used. Glass fibers may have a round cross-section or an elliptic cross-section (also called flat fibers).

If present, the reinforcing filler is preferably present in an amount of at least 2 wt. %, more preferably at least 4 wt. %, still more preferably at least 5 wt. %, and most preferably at least 10 wt. %, based on the total weight of the polymer composition (C). When present, the reinforcing filler is also preferably present in an amount of at most 40 wt. %, more preferably at most 30 wt. %, still more preferably at most 25 wt. %, and most preferably at most 20 wt. %, based on the total weight of the polymer composition (C).

Excellent results were obtained when the reinforcing filler was present in the composition in an amount from about 5 to about 40 wt. %, preferably from about 5 to about 25 wt. %, and more preferably from about 10 to about 20 wt. %, based on the total weight of the polymer composition (C).

The polymer composition (C) can further contain one or more impact modifiers. The impact modifiers can be reactive with the polyester (P) or non-reactive. In certain specific embodiment, the polymer composition (C) contains at least one reactive impact modifier and at least one non-reactive impact modifier.

Reactive impact modifiers that may be used include ethylene-maleic anhydride copolymers, ethylene-alkyl (meth)acrylate-maleic anhydride copolymers, ethylene-alkyl (meth)acrylate-glycidyl (meth)acrylate copolymers, and the like. An example of such reactive impact modifier is a random terpolymer of ethylene, methylacrylate and glycidyl methacrylate.

Non-reactive impact modifiers that may be blended into the polymer composition (C) generally include various rubber materials, such as acrylic rubbers, ASA rubbers, diene rubbers, organosiloxane rubbers, EPDM rubbers, SBS or SEBS rubbers, ABS rubbers, NBS rubbers and the like. Particular examples of non-reactive impact modifiers include ethyl butylacrylate, ethyl (methyl)acrylate or 2 ethyl hexyl acrylate copolymers.

If present, the impact modifier is preferably present in an amount of at least 2 wt. %, more preferably at least 4 wt. %, still more preferably at least 5 wt. %, and most preferably at least 10 wt. %, based on the total weight of the polymer composition (C). When present, the impact modifier is also preferably present in an amount of at most 20 wt. %, more preferably at most 15 wt. %, still more preferably at most 10 wt. %, and most preferably at most 5 wt. %, based on the total weight of the polymer composition (C).

The polymer composition (C) may optionally further contain up to about 3 wt. % of ultraviolet light stabilizers or UV blockers. Examples include triazoles and triazines, oxanilides, hydroxybenzophenones, benzoates, and α-cyanoacrylates. When present, the ultraviolet light stabilizers are preferably present in an amount of about 0.1 to about 3 wt. %, or preferably about 0.1 to about 1 wt. %, or more preferably about 0.1 to about 0.6 wt. %, of the total weight of the polymer composition (C).

The polymer composition (C) may also comprise other optional ingredients such as mold release agents, lubricants, optical brighteners and other stabilizers, different from the ones described above. However, the polymer composition (C) is preferably free from any oxidized polyethylene wax.

As described above, the polymer composition (C) has excellent reflectance properties. For example, the polymer composition (C) can have an initial reflectance at 460 nm of greater than about 85 %, preferably greater than about 86 %, more preferably greater than about 88 %, still more preferably greater than about 90 %, as measured according to ASTM E-1331-09 using a D65 illuminant with a 10° observer.

The polymeric composition (C) can also have an initial whiteness index of greater than about 85 %, preferably greater than about 86 %, more preferably greater than about 87 %, as measured according to ASTM E-313-10. Of particular advantage, the polymeric material can have a whiteness index after aging at 200°C for four hours of greater than about 70 %, greater than about 75 %, preferably greater than about 78 %, more preferably greater than about 80 %, as measured according to ASTM E-313-10.

The polymer composition (C) can also have a whiteness index retention after aging at 200°C for four hours of greater than about 80 percent, preferably greater than about 85 %, more preferably greater than about 90 %, as measured according to ASTM E-313-10.

Any melt-mixing method may be used to combine the polymeric components and non-polymeric ingredients to prepare the polymer composition (C). For example, the polymeric components and non-polymeric ingredients may be added to a melt mixer, such as, for example, a single or twinscrew extruder, a blender or a Banbury mixer, either all at once through a single step addition, or in a stepwise fashion, and then melt-mixed. When adding the polymeric components and non-polymeric ingredients in a stepwise fashion, part of the polymeric components and/or non-polymeric ingredients are first added and melt-mixed with the remaining polymeric components and non-polymeric ingredients are subsequently added and further melt-mixed until a well-mixed composition is obtained.

An aspect of the present invention also provides an article comprising at least one part comprising the polymer composition (C), which provides various advantages over prior art parts and articles, in particular an increased resistance to concurrent exposure to heat and light while maintaining all their other properties at a high level.

In a particular embodiment, the article is a light emission apparatus.

Non limitative examples of light emission apparatuses are keyless entry systems of an automobile, lightings in a refrigerator, liquid crystal display apparatuses, automobile front panel lighting apparatuses, desk lamps, headlights, household electrical appliance indicators and outdoor display apparatuses such as traffic signs, and optoelectronic devices comprising at least one semi-conductor chip that emits and/or transmits electromagnetic radiation commonly known as Light Emitting Diodes devices (LEDs). Preferably, the light emission apparatus is a LED device.

As used herein, the terms "light emitting diode device" and "LED device" intend to denote a device comprising at least one light emitting diode, an electrical connection capable of connecting the diode to an electrical circuit, and a housing partially surrounding the diode. The LED device may optionally have a lens that fully or partially covers the LED.

LEDs are preferably chosen from the group of top view LEDs, side view LEDs and power LEDs. The top view LEDs are notably used in automotive lighting applications such as panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

The articles of the present invention may be incorporated into LED devices used in applications such as traffic signals, large area displays, video screens, interior and exterior lighting, cellular telephone display backlights, automotive displays, vehicle brake lights, vehicle head lamps, laptop computer display backlights, pedestrian floor illumination and flashlights.

The articles of the present invention are preferably parts of a LED device such as housings, reflectors and heatsinks.

The articles prepared from the polymer composition (C) may be manufactured by any suitable melt-processing method known to those skilled in the art, such as injection molding or the like.

The articles may be overmolded over a metal (such as copper or silver-coated copper) lead frame that can be used to make an electrical connection to an LED inserted into the housing. The article preferably has a cavity in the portion of the housing that surrounds the LED, which serves to reflect the LED light in the outward direction and towards a lens, if one is present. The cavity may be in a cylindrical, conical, parabolic or other curved form, and preferably has a smooth surface. Alternatively, the walls of the cavity may be parallel or substantially parallel to the diode. A lens may be formed over the diode cavity and may comprise an epoxy or silicone material.

Preferably at least 50 wt. % and more preferably more than 80 wt. % of the part comprises the polymer composition (C) (the part can possibly further contain notably a metal; for example, for certain end uses, the surface of the part acting as reflector may be metal plated). More preferably, more than 90 wt. % of the part comprises the polymer composition (C). Still more preferably, the part consists essentially of the polymer composition (C). The most preferably, the part consists of the polymer composition (C).

## EXAMPLES

The disclosure will now be illustrated with working examples, which are intended to illustrate the present invention and are not intended to restrictively imply any limitations on the scope of the present disclosure.

The following commercially available materials were used :

*Polyester :* PCT Polyester from Eastman™ Chemical Products.
*Glass fiber : E-glass fiber* commercially available from OCV™ Reinforcements as OCV 995.
*Titanium Dioxide* 1: TIPAQUE® PC-3 available from Ishihara Sangyo Kaisha, Ltd - rutile $TiO_2$.
*Titanium Dioxide* 2: TIPAQUE® PF691 available from Ishihara Sangyo Kaisha, Ltd - rutile $TiO_2$.
*Stabilizers :* the same amounts of two stabilizers were used throughout the experiments, namely Hostanox® P-EPQ and Nylostab® S-EED both commercially available from Clariant™.
*Additives :*
Chemical nucleating agent 1 : sodium montanate commercially available from Clariant™ as Licomont Nav 101.
Chemical nucleating agent 2 : sodium stearate commercially available from Alfa Aesar.
Melt miscible nucleating agent: ethylene-acrylic acid sodium ionomer commercially available from Honeywell International as AClyn®.
Inorganic nucleating agent: talc commercially available from IMI Fabi™ as HTP4.
Plasticizer 1 : neopentyl glycol dibenzoate commercially available from Lanxess as Uniplex™ 512.
Plasticizer 2 : PEG-400 di-2-ethylhexanoate commercially available from Lanxess as Uniplex™ 809.
Plasticizer 3 : trioctyl trimellitate commercially available from Sigma-Aldrich.
Lubricant 1 : LLDPE commercially available from Dow Chemical Company as LLDPE GRSN-9820.
Lubricant 2 : LICOWAX® PED 191, a high molecular weight oxidized polyethylene wax commercially available from AmeriLubes, L.L.C.

## General procedure for the preparation of the compositions

The polyester resin described above was fed to the first barrel of a ZSK-26 twin screw extruder comprising 12 zones via a loss in weight feeder. The barrel set-point temperatures were in the range of 150-300°C and the resins were melted before zone 5. The other solid ingredients were fed at zone 5 through a side stuffer via a loss in weight feeder. The liquid ingredients were fed at zone 7. The screw rate was in the range of 150-200 rpm. The extrudates were cooled and pelletized using conventional equipment.

The nature and quantity of the various ingredients used are summarized in Table 1, indicating the amount of each ingredient in weight percent.

## Reflectance measurements

Behavior of a part made from the inventive composition in a LED device has been simulated by exposing samples at 260°C for 10 minutes. Therefore, each one of the compositions of example E6-E8 and comparative examples CE1-CE5 were used to prepare discs of about 50 mm diameter with a thickness of about 1.6 mm.

Another heat aging test was performed on ISO bars molded from compositions CE1-CE3 and E6-E8 by exposing them at 200°C for 4 hours.

Reflectances were measured on a BKY-Gardner photo-spectrometer according to ASTM E-1331-09 using a D65 illuminant with a 10° observer. The average reflectance results on the original molded parts and on the same parts after exposure to high heat (260°C for 10 minutes for the discs and 200°C for 4 hours for the ISO bars) obtained on at least 3 samples are summarized in Table 6, as well as the percentages of retention of reflectance at a wavelength of 460 nm.

XYZ coordinates were obtained from the same scans and the whiteness index was calculated using ASTM E-313-10.

**Table 1 : Nature and quantity in weight % of the ingredients used**

|  | (CE1) | (CE2) | (CE3) | (CE4) | (CE5) | (E6) | (E7) | (E8) |
|---|---|---|---|---|---|---|---|---|
| **Polyester** | 62.3 | 60.3 | 58.3 | 55.1 | 62.05 | **55.3** | **55.3** | **55.3** |
| **Reinforcing filler** | 15 | 15 | 17 | 17 | 15 | **17** | **17** | **17** |
| **White pigment 1** | 20 | 20 | 20 | 20 | - | **20** | **20** | **20** |
| **White pigment 2** | - | - | - | - | 20 | - | - | - |
| **Chemical nucleating agent 1** | - | 3 | - | - | - | - | - | - |
| **Chemical nucleating agent 2** | - | - | - | 0.7 | - | - | - | - |
| **Melt miscible nucleating agent** | - | - | - | 3 | - | - | - | - |
| **Inorganic nucleating agent** | 1 | - | 3 | - | 1 | **3** | **3** | **3** |
| **Plasticizer 1** | - | - | - | 2 | - | **3** | - | - |
| **Plasticizer 2** | - | - | - | - | - | - | **3** | - |
| **Plasticizer 3** | - | - | - | - | - | - | - | **3** |
| **Stabilizers** | 1.2 | 1.2 | 1.2 | 1.2 | 1.2 | **1.2** | **1.2** | **1.2** |
| **Lubricant 1** | 0.5 | 0.5 | 0.5 | 0.5 | - | **0.5** | **0.5** | **0.5** |
| **Lubricant 2** | - | - | - | - | 0.75 | - | - | - |

**Table 2 : Reflectance measurements on discs after heat treatment at 260°C**

| Reflectance at 460 nm (%) | (CE1) | (CE2) | (CE3) | (CE4) | (CE5) | (E6) | (E7) | (E8) |
|---|---|---|---|---|---|---|---|---|
| - as molded | 93.0 | 88.0 | 92.4 | 77.0 | 92.0 | **92.0** | **93.1** | **92.5** |
| - after 10 min at 260°C | 91.0 | 34.0 | 90.7 | 15.0 | 87.0 | **90.5** | **90.5** | **91.2** |
|  |  |  |  |  |  |  |  |  |
| **Reflectance retention (%)** | 98 | 39 | 98 | 19 | 94.6 | **98** | **97** | **99** |

**Table 3 : Whiteness index and reflectance measurements on ISO bars after heat treatment at 200°C**

|  | (CE1) | (CE2) | (CE3) | (E6) | (E7) | (E8) |
|---|---|---|---|---|---|---|
| **Whiteness index** |  |  |  |  |  |  |
| - as molded | 87.1 | 78.9 | 87.9 | **87.7** | **87.9** | **87.5** |
| - after 4 hours at 200°C | 79.8 | 36.1 | 82.3 | **81.8** | **80.2** | **81.5** |
|  |  |  |  |  |  |  |
| **Whiteness index retention (%)** | 92 | 46 | 94 | **93** | **91** | **93** |
|  |  |  |  |  |  |  |
| **Reflectance at 460 nm (%)** |  |  |  |  |  |  |
| - as molded | 93.6 | 88.8 | 92.4 | **91.3** | **92.8** | **92.0** |
| - after 4 hours at 200°C | 89.5 | 64.1 | 90.1 | **89.1** | **89.2** | **89.5** |
|  |  |  |  |  |  |  |
| **Reflectance retention (%)** | 96 | 72 | 98 | **98** | **96** | **97** |

**Table 4 : Crystallization rate**

|  | (CE1) | (CE2) | (CE3) | (CE4) | **(E6)** | **(E7)** | **(E8)** |
|---|---|---|---|---|---|---|---|
| Crystallization rate | -- | ++ | -- | / | ++ | +++ | + |

**Results**

As it may be seen from the data presented in Table 2, the compositions according to the present invention (E6, E7 and E8) surprisingly show higher retention of reflectance after exposure to high heat for 10 minutes compared to comparative examples CE2, CE4 and CE5.

CE5 has been prepared to demonstrate the fact that the presence of oxidized polyethylene wax, which appears to be the lubricant of choice of WO 2012/141967, is detrimental to the reflectance retention of the compositions after 10 min at 260°C (compare CE1 and CE5).

Also, for sake of comparison with the behavior of compositions disclosed in US 2012/0262927, the compositions CE1, CE2, CE3, E6, E7 and E8 were also subjected to another type of heat treatment (i.e. 4 hours at 200°C). The obtained whiteness index and reflectance data are summarized in Table 3. Compositions of examples E6, E7 and E8 demonstrate excellent whiteness index retentions of at least 91 % while the compositions disclosed in US 2012/0262927 (see Examples 1 to 9 on page 7) feature a maximum of 84 % in whiteness index retention.

The data summarized in Table 4 also well demonstrate the excellent crystallization rates of the examples E6, E7 and E8 according to the present invention (+ to +++).

The minimum required mold temperatures for the exemplified compounds were determined by molding test bars at different mold temperatures. The dimensions of the test bars were 5 inches long by 1/2 inch wide and by 1/32 inch thick, which is the typical thickness of an LED's thickest section. The percentage of maximum crystallinity was then measured using a DSC (differential scanning calorimeter) and plotted against measured mold steel temperature. The percent of crystallinity was calculated using the formula :

$$(1 - \Delta H_{cc}/\Delta H_f) \times 100$$

where $\Delta H_{cc}$ is the heat of cold crystallization and $\Delta H_f$ is the heat of fusion for the material, as measured by DSC.

Both enthalpies of fusion and cold crystallization were measured on 5-10 mg samples of the molded test bars according to ASTM D-3428 using a heating rate of 20°C/minute. Cold crystallization peak only appeared on the scan around the Tg of the material if the test bar was not fully crystallized.

Figure 1 shows thus a graph depicting the degree of crystallinity as measured on examples CE1, CE2, CE3, E6, E7 and E8 as a function of the mold temperature. The minimum mold temperature was easily determined from the graph by observing at what temperature the crystallinity reaches 100 % of maximum possible crystallinity. Compositions CE1 and CE3 have a very low crystallization rate, whereas CE2, E6 and E8 feature a good crystallization rate achieving full crystallinity between 110 and 120°C. Interestingly, E7 shows an excellent crystallization rate reaching 100 % crystallinity even at lower temperature.

Comparative examples CE1 and CE3 comprising the inorganic nucleating agent (at 1 wt. % and 3 wt. %) both feature a low crystallization rate and a good retention of reflectance.

Comparative example CE2 comprising the chemical nucleating agent features a good crystallization rate and a low retention of reflectance.

Comparative example CE4 comprising a chemical nucleating agent, a melt-miscible nucleating agent and a plasticizer, based on the recommendation set forth for PET (as laid out in Chapter 14 of Modern Polyesters, edited by Timothy E. Long and John Scheirs, published by Wiley), is very disappointing with a dramatic result on both initial reflectance and reflectance retention after heat treatment. Therefore, crystallization rate has not been evaluated on this compound.

Examples E6, E7 and E8 according to the present invention comply with a wide set of requirements as set forth previously (notably good processability, high dimensional stability, high mechanical strength) and also surprisingly feature a reflectance after high heat treatment of more than 90 %. Those compositions are therefore excellent candidates for the manufacture of LED components.

**Claims**

1. A polymer composition (C) comprising :

    - at least one polyester (P) comprising at least 50 mol % of recurring units comprising at least one cycloaliphatic group,
    - at least one white pigment selected from the group consisting of $TiO_2$, ZnS, ZnO, $CeO_2$ and $BaSO_4$,
    - at least one inorganic nucleating agent, and
    - at least one plasticizer having a boiling point of at least 200°C, present in an amount of at least 1 wt. % and at most 4 wt. %, based on the total weight of the polymer composition (C), and selected from the group consisting of phthalate esters, trimellitate esters, benzoate esters, terephthalate esters, citrate esters, cyclohexane diacid esters and esters of oligomers/polymers of ethers.

2. Polymer composition (C) according to claim 1, wherein the polyester (P) is present in an amount of 45-60 wt. %, based on the total weight of the composition.

3. Polymer composition (C) according to anyone of the preceding claims, wherein at least 50 mol % of the recurring units of the polyester (P) are obtained through the polycondensation of terephthalic acid with 1,4-cyclohexylenedimethanol.

4. Polymer composition (C) according to anyone of the preceding claims, wherein the polyester (P) is poly(1,4-cyclohexylenedimethylene terephthalate).

5. Polymer composition (C) according to anyone of the preceding claims, wherein the at least one inorganic nucleating agent is selected from the group consisting of silica, talc, clay, alumina, mica, zirconia, titania, tin oxide, tin indium oxide, antimony tin oxide, calcium carbonate and zeolites.

6. Polymer composition (C) according to anyone of the preceding claims, wherein the at least one inorganic nucleating agent is present in an amount of 1 to 5 wt. %, based on the total weight of the polymer composition (C).

7. Polymer composition (C) according to anyone of the preceding claims, wherein the at least one plasticizer is selected from the group consisting of trimellitate esters, benzoate esters, and esters of oligomers/polymers of ethers.

8. Polymer composition (C) according to claim 7, wherein the at least one plasticizer is selected from the group consisting of trioctyl trimellitate,neopentyl glycol dibenzoate and PEG-400 di-2-ethylhexanoate.

9. Polymer composition (C) according to anyone of the preceding claims, wherein the white pigment is $TiO_2$.

10. Polymer composition (C) according to anyone of the preceding claims, wherein it further comprises at least one reinforcing filler selected from the group consisting of glass fiber and wollastonite.

11. Polymer composition (C) according to claim 10, wherein the reinforcing filler is present in 5-40 wt. %, based on the total weight of the polymer composition (C).

12. An article comprising at least one part comprising the polymeric composition (C) according to any one of the preceding claims.

13. The article according to claim 12, wherein the article is a light emitting diode (LED) device.

14. The article according to claim 13, wherein the part is a reflector.

**Patentansprüche**

1. Polymerzusammensetzung (C), umfassend :

    - mindestens einen Polyester (P), der mindestens 50 Mol-% Wiederholungseinheiten mit mindestens einer cycloaliphatischen Gruppe umfasst,

- mindestens ein Weißpigment aus der Gruppe bestehend aus $TiO_2$, ZnS, ZnO, $CeO_2$ und $BaSO_4$,
- mindestens ein anorganisches Nukleierungsmittel und
- mindestens einen Weichmacher mit einem Siedepunkt von mindestens 200 °C, der in einer Menge von mindestens 1 Gew.-% und höchstens 4 Gew.-%, bezogen auf das Gesamtgewicht der Polymer zusammensetzung (C), vorliegt und aus der Gruppe bestehend aus Phthalatestern, Trimellitatestern, Benzoatestern, Terephthalatestern, Citratestern, Cyclohexandisäureestern und Estern von Oligomeren/Polymeren von Ethern ausgewählt ist.

2. Polymerzusammensetzung (C) nach Anspruch 1, wobei der Polyester (P) in einer Menge von 45-60 Gew.-%, bezogen auf das Gesamtgewicht der Zusammensetzung, vorliegt.

3. Polymerzusammensetzung (C) nach einem der vorhergehenden Ansprüche, wobei mindestens 50 Mol-% der Wiederholungseinheiten des Polyesters (P) durch die Polykondensation von Terephthalsäure mit 1,4-Cyclohexylendimethanol erhalten werden.

4. Polymerzusammensetzung (C) nach einem der vorhergehenden Ansprüche, wobei es sich bei dem Polyester (P) und Poly(1,4-cyclohexylendimethylenterephthalat) handelt.

5. Polymerzusammensetzung (C) nach einem der vorhergehenden Ansprüche, wobei das mindestens eine organische Nukleierungsmittel aus der Gruppe bestehend aus Siliciumdioxid, Talk, Ton, Aluminiumoxid, Glimmer, Zirconiumdioxid, Titandioxid, Zinnoxid, Zinnindiumoxid, Antimonzinnoxid, Calciumcarbonat und Zeolithen ausgewählt ist.

6. Polymerzusammensetzung (C) nach einem der vorhergehenden Ansprüche, wobei das mindestens eine anorganische Nukleierungsmittel in einer Menge von 1 bis 5 Gew.-%, bezogen auf das Gesamtgewicht der Polymerzusammensetzung (C), vorliegt.

7. Polymerzusammensetzung (C) nach einem der vorhergehenden Ansprüche, wobei der mindestens eine Weichmacher aus der Gruppe bestehend aus Trimellitatestern, Benzoatestern und Estern von Oligomeren/Polymeren von Ethern ausgewählt ist.

8. Polymerzusammensetzung (C) nach Anspruch 7, wobei der mindestens eine Weichmacher aus der Gruppe bestehend aus Trioctylmellitat, Neopentylglykoldibenzoat und PEG-400-Di-2-ethylhexanoat ausgewählt ist.

9. Polymerzusammensetzung (C) nach einem der vorhergehenden Ansprüche, wobei es sich bei dem Weißpigment um $TiO_2$ handelt.

10. Polymerzusammensetzung (C) nach einem der vorhergehenden Ansprüche, wobei sie ferner mindestens einen verstärkenden Füllstoff aus der Gruppe bestehend aus Glasfaser und Wollastonit umfasst.

11. Polymerzusammensetzung (C) nach Anspruch 10, wobei der verstärkende Füllstoff in einer Menge von 5-40 Gew.-%, bezogen auf das Gesamtgewicht der Polymerzusammensetzung (C), vorliegt.

12. Gegenstand, umfassend mindestens einen Teil, der die Polymerzusammensetzung (C) nach einem der vorhergehenden Ansprüche umfasst.

13. Gegenstand nach Anspruch 12, wobei es sich bei dem Gegenstand um eine Leuchtdioden(LED)-Vorrichtung handelt.

14. Gegenstand nach Anspruch 13, wobei es sich bei dem Teil um einen Reflektor handelt.

**Revendications**

1. Composition de polymère (C) comprenant :

- au moins un polyester (P) comprenant au moins 50 % en mole de motifs récurrents comprenant au moins un groupe cycloaliphatique,
- au moins un pigment blanc choisi dans le groupe constitué par $TiO_2$, ZnS, ZnO, $CeO_2$ et $BaSO_4$,
- au moins un agent de nucléation inorganique et

- au moins un plastifiant ayant un point d'ébullition d'au moins 200 °C, présent en une quantité d'au moins 1 % en poids et d'au maximum 4 % en poids, par rapport au poids total de la composition de polymère (C), et choisi dans le groupe constitué par les esters de l'acide phtalique, les esters de l'acide trimellitique, les esters de l'acide benzoïque, les esters de l'acide téréphtalique, les esters de l'acide citrique, les esters de diacides de cyclohexane et les esters d'oligomères/polymères d'éthers.

2. Composition de polymère (C) selon la revendication 1, dans laquelle le polyester (P) est présent en une quantité de 45-60 % en poids, par rapport au poids total de la composition.

3. Composition de polymère (C) selon l'une quelconque des revendications précédentes, dans laquelle au moins 50 % en mole des motifs récurrents du polyester (P) sont obtenus par la polycondensation d'acide téréphtalique avec du 1,4-cyclohexylènediméthanol.

4. Composition de polymère (C) selon l'une quelconque des revendications précédentes, dans laquelle le polyester (P) est du poly(téréphtalate de 1,4-cyclohexylènediméthylène).

5. Composition de polymère (C) selon l'une quelconque des revendications précédentes, dans laquelle l'au moins un agent de nucléation inorganique est choisi dans le groupe constitué par la silice, le talc, l'argile, l'alumine, le mica, la zircone, le dioxyde de titane, l'oxyde d'étain, l'oxyde d'étain et d'indium, l'oxyde d'antimoine et d'étain, le carbonate de calcium et les zéolites.

6. Composition de polymère (C) selon l'une quelconque des revendications précédentes, dans laquelle l'au moins un agent de nucléation inorganique est présent en une quantité de 1 à 5 % en poids, par rapport au poids total de la composition de polymère (C).

7. Composition de polymère (C) selon l'une quelconque des revendications précédentes, dans laquelle l'au moins un plastifiant est choisi dans le groupe constitué par les esters de l'acide trimellitique, les esters de l'acide benzoïque et les esters d'oligomères/polymères d'éthers.

8. Composition de polymère (C) selon la revendication 7, dans laquelle l'au moins un plastifiant est choisi dans le groupe constitué par le trimellitate de trioctyle, le dibenzoate de néopentylglycol et le di-2-éthylhexanoate de PEG-400.

9. Composition de polymère (C) selon l'une quelconque des revendications précédentes, dans laquelle le pigment blanc est $TiO_2$.

10. Composition de polymère (C) selon l'une quelconque des revendications précédentes, comprenant en outre au moins une charge renforçante choisie dans le groupe constitué par les fibres de verre et la wollastonite.

11. Composition de polymère (C) selon la revendication 10, dans laquelle la charge renforçante est présente à hauteur de 5-40 % en poids, par rapport au poids total de la composition de polymère (C).

12. Article comprenant au moins une partie comprenant la composition polymère (C) selon l'une quelconque des revendications précédentes.

13. Article selon la revendication 12, l'article étant un dispositif à diode électroluminescente (DEL).

14. Article selon la revendication 13, dans lequel la partie est un réflecteur.

Figure 1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007033129 A
- US 20120262927 A
- WO 2012141967 A

**Non-patent literature cited in the description**

- Additives for Plastics Handbook. John Murphy, 43-48
- Modern Polyesters. Wiley